Europäisches Patentamt

European Patent Office

Office européen des brevets

(11) Numéro de publication: **0 145 521**
**A1**

# DEMANDE DE BREVET EUROPEEN

(21) Numéro de dépôt: **84401972.9**

(51) Int. Cl.⁴: **G 01 R 29/16**

(22) Date de dépôt: **03.10.84**

(30) Priorité: **05.10.83 FR 8315865**

(43) Date de publication de la demande: **19.06.85**
**Bulletin 85/25**

(84) Etats contractants désignés: **CH DE GB LI**

(71) Demandeur: **PETERCEM S.A., 61, Route de Grenoble B.P. 320, F-69808 Saint Priest-Cédex (FR)**

(72) Inventeur: **Peralta, François Jean, 18, Rue René Bazin, F-69330 Meyzieu (FR)**

(74) Mandataire: **Laget, Jean-Loup et al, Cabinet Pierre Loyer 18, Rue de Mogador, F-75009 Paris (FR)**

(54) **Procédé et dispositif de contrôle du courant d'alimentation d'un récepteur polypole.**

(57) Dispositif de contrôle du courant d'alimentation d'un récepteur polypole.

Deux capteurs 6 et 9 élaborent deux courants $\vec{i}_A$ et $\vec{i}_B$ images déphasés d'un angle $\varphi$ représentatif de l'équilibre des courants de phase.

Procédé et dispositif de contrôle du courant d'alimentation
d'un récepteur polypole.

L'invention est relative au contrôle du courant d'alimentation
d'un récepteur polypole.

Un récepteur électrique polypole est alimenté en courant polyphasé, et il importe de contrôler ce courant, d'une part en ce
qui concerne l'amplitude du courant par phase, d'autre part en
ce qui concerne l'équilibre des courants de phase.

Usuellement, les mesures de l'intensité du courant dans chaque
phase d'alimentation d'un récepteur polypole sont effectuées au
moyen d'un transformateur d'intensité. Dans le cas où la sensibilité du signal fourni est faible, inférieure par exemple au
mV/A, on peut utiliser comme capteur de courant alternatif sinusoïdal une bobine de Rogowski à tore amagnétique.

L'un des buts de l'invention est de proposer un dispositif simple de contrôle du courant d'alimentation d'un récepteur polypole, qui présente une sensibilité accrue, en fournissant un
signal image du courant contrôlé.
Un autre but de l'invention est, grâce au même dispositif de détecter un déséquilibre des courants de phase alimentant symétriquement un récepteur.

La présente invention a pour objet un procédé de contrôle du
courant d'alimentation d'un récepteur polypole, caractérisé en
ce que l'on élabore, au moyen d'un capteur du type bobine de
Rogowski ou transformateur d'intensité, un courant image d'un courant de phase, d'amplitude supérieure à celle dudit courant de phase.

Selon l'invention, ce procédé est caractérisé en ce que, au moyen d'un premier capteur, on élabore un premier courant image $\overrightarrow{i_B}$, et au moyen d'un second capteur combiné au premier on élabore un second courant image $\overrightarrow{i_A}$, en ce qu'on mesure le déphasage entre lesdits courants images, et en ce qu'on utilise ce déphasage comme témoin de l'équilibre des courants de phase alimentant le récepteur.

L'invention a également pour objet un dispositif de contrôle du courant d'alimentation d'un récepteur polypole, caractérisé en ce qu'il comporte un premier capteur traversé en sens inverses par deux courants de phase $\overrightarrow{i_1}$ et $\overrightarrow{i_3}$ de façon à élaborer un premier courant image $\overrightarrow{i_B}$ ; un deuxième capteur traversé par trois courants de phase dont l'un $\overrightarrow{i_1}$ en sens inverse des deux autres $\overrightarrow{i_2}$ et $\overrightarrow{i_3}$ de façon à élaborer, en combinaison avec le premier capteur un deuxième courant image $\overrightarrow{i_A}$ ; et un dispositif de mesure et de traitement susceptible de mesurer le déphasage entre lesdits courants images et de contrôler ce déphasage représentatif de l'équilibre des courants de phase.

Selon une caractéristique de l'invention, les capteurs sont des bobines de Rogowski ou des transformateurs d'intensité.

A titre d'illustration et pour faciliter la compréhension de l'invention, on a représenté au dessin annexé :

Figure 1 - un schéma simplifié illustrant le principe de l'invention pour élaborer un signal image du courant d'alimentation d'un récepteur polypole ;

Figure 2 - un schéma électrique simplifié d'un dispositif de contrôle du courant d'alimentation d'un récepteur polypole, selon l'invention ;

Figure 3 - le diagramme de Fresnel représentant les courants dans le dispositif de contrôle de la figure 2.

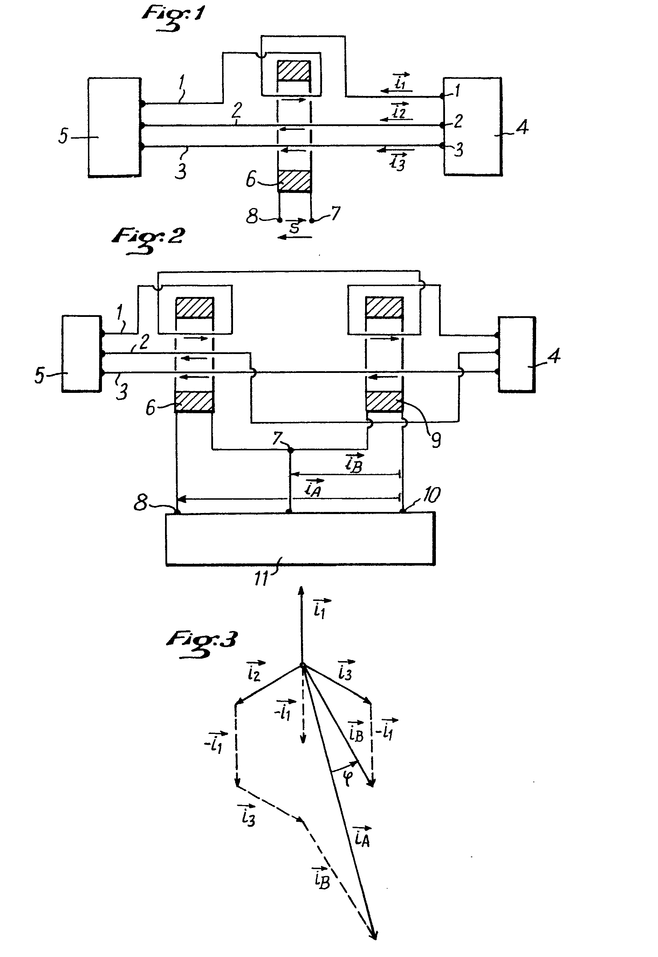

En se reportant au dessin, on peut voir (figure 1) un générateur 4 triphasé, alimentant un récepteur 5 également triphasé. Les courants dans chacune des phases sont liés par la relation fondamentale :

$$\vec{i_1} + \vec{i_2} + \vec{i_3} = \vec{0}$$

Si l'on mesure chaque courant individuellement, on obtient pour chacun un signal proportionnel à l'amplitude du courant.

Le principe de l'invention est de combiner des courants pour obtenir un signal image d'amplitude plus grande pour accroître la sensibilité. Ainsi, on élabore un courant

$$\vec{im} = \vec{-i_1} + \vec{i_2} + \vec{i_3}$$

D'après la relation fondamentale précitée.

$$\vec{i_2} + \vec{i_3} = \vec{-i_1}$$

et

$$\vec{im} = -2\,\vec{i_1}$$

Si l'on mesure ce courant $\vec{im}$ au moyen d'un capteur, on peut voir que la sensibilité du capteur se trouve multipliée par deux.

Pour réaliser le montage correspondant, on utilise une bobine de Rogowski 6 traversée dans un sens par les deux conducteurs 2 et 3 des courants $\vec{i_2}$ et $\vec{i_3}$, et dans l'autre sens par le conducteur 1 du courant $\vec{i_1}$. Entre les bornes 7 et 8 de cette bobine 6, le signal mesuré $\vec{s}$ est alors :

$$\vec{s} = N\ S\ \mu\ \frac{d\,\vec{im}}{dt}$$

avec N = nombre de tours linéiques sur tout le périmètre moyen de tore,

    S = section du tore,

- 4 -

$\mu$ = perméabilité magnétique du noyau torique

im = Im sin $(2\pi f \ t)$

f = fréquence du courant d'alimentation.

On peut écrire

$\quad$ S = 2 $\pi$ f Im . N S $\mu$ cos $(2\pi f t)$.

On voit qu'avec une seule bobine, on a un dispositif de contrôle simple à sensibilité améliorée.

Le montage de la figure 2 est particulièrement adapté au contrôle ou à la surveillance d'un récepteur électrique, et il permet de réduire les coûts en limitant le nombre des capteurs tout en améliorant la sensibilité des mesures.

Dans ce montage, entre le générateur 4 et le récepteur 5 sont disposées deux bobines de Rogowski 6 et 9. La première bobine 6 est traversée par les conducteurs 1, 2 et 3 comme dans le cas de la figure 1. La deuxième bobine 9 est traversée dans un sens par le conducteur 3 et en sens inverse par le conducteur 1. Elle n'est pas traversée par le conducteur 2. Cette deuxième bobine a une borne d'entrée 10 reliée directement au dispositif 11 de mesure et de traitement de signaux. Sa borne de sortie est reliée à la borne d'entrée 7 de la première bobine 6, qui est elle-même reliée directement au dispositif 11 de mesure. La borne de sortie 8 de la première bobine 6 est également reliée directement au dispositif 11 de mesure.

Le dispositif de mesure reçoit donc entre les bornes 10 et 7 un signal

$$\vec{i}_B = -\vec{i}_1 + \vec{i}_3$$

en provenance de la deuxième bobine 9, et entre les bornes 10 et 8 un signal

$$\vec{i}_A = \vec{i}_B - \vec{i}_1 + \vec{i}_2 + \vec{i}_3$$

en provenance de l'ensemble des deux bobines 9 et 6.

Le diagramme de Fresnel de la figure 3 représente les courants $\vec{i}_B$ et $\vec{i}_A$ élaborés à partir de $\vec{i}_1$, $\vec{i}_2$, et $\vec{i}_3$.

On peut en déduire par le calcul

$$\left|\vec{i_A}\right| = \sqrt{13} \quad \left|\vec{i_1}\right| \simeq 3{,}61 \quad \left|\vec{i_1}\right|$$

$$\left|\vec{i_B}\right| = \sqrt{3} \quad \left|\vec{i_1}\right|$$

Le déphasage entre les deux courants $\vec{i_A}$ et $\vec{i_B}$ est dans ce cas

$$\varphi = \text{Arc cos } 2\sqrt{3} \: / \: \sqrt{13} \simeq 16° \: 6'$$

En associant ainsi les deux bobines 6 et 9, on réalise un capteur permettant à un dispositif de mesure 11 de mesurer, directement et avec une grande sensibilité, deux courants $\vec{i_A}$ et $\vec{i_B}$. Le dispositif de mesure 11 fournit donc une image $\vec{i_A}$ du courant $\vec{i_1}$, de grande amplitude, déphasée par rapport à $\vec{i_1}$ d'un angle défini égal à $(\tilde{\Pi} - \left|\tilde{\Pi}/6 - |\varphi|\right|)$. Le dispositif 11 fournit également, après traitement, le déphasage $\varphi$ de $\vec{i_B}$ par rapport à $\vec{i_A}$. Ce déphasage est le témoin de l'équilibre des courants de phase, et reste constant en cas d'équilibre. Il faut remarquer que dans l'exemple décrit, on utilise des bobines de Rogowski, mais que les transformateurs d'intensité sont également utilisables.

Revendications

1. Procédé de contrôle du courant d'alimentation d'un récepteur polypole, caractérisé en ce que l'on élabore, au moyen d'un capteur du type bobine de Rogowski ou transformateur d'intensité, un courant image d'un courant de phase, d'amplitude supérieure à celle dudit courant de phase.

2. Procédé selon la revendication 1, caractérisé en ce que, au moyen d'un premier capteur, on élabore un premier courant image $\overrightarrow{i_B}$, et au moyen d'un second capteur combiné au premier on élabore un second courant image $\overrightarrow{i_A}$, en ce qu'on mesure le déphasage entre lesdits courants images, et en ce qu'on utilise ce déphasage comme témoin de l'équilibre des courants de phase alimentant le récepteur.

3. Dispositif de contrôle du courant d'alimentation d'un récepteur polypole, caractérisé en ce qu'il comporte un premier capteur (9) traversé en sens inverses par deux courants de phase ($\overrightarrow{i_1}$) et ($\overrightarrow{i_3}$) de façon à élaborer un premier courant image ($\overrightarrow{i_B}$) ; un deuxième capteur (6) traversé par trois courants de phase dont l'un ($\overrightarrow{i_1}$) en sens inverse des deux autres ($\overrightarrow{i_2}$ et $\overrightarrow{i_3}$) de façon à élaborer, en combinaison avec le premier capteur (9) un deuxième courant image ($\overrightarrow{i_A}$) ; et un dispositif (11) de mesure et de traitement susceptible de mesurer le déphasage entre lesdits courants images et de contrôler ce déphasage représentatif de l'équilibre des courants de phase.

4. Dispositif selon la revendication 3, caractérisé en ce que lesdits capteurs sont des bobines de Rogowski ou des transformateurs d'intensité.

0145521

1/1

Fig:1

Fig:2

Fig:3

# RAPPORT DE RECHERCHE EUROPEENNE

Office européen des brevets

Numéro de la demande

**0145521**

EP 84 40 1972

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | FR-A- 608 749 (COMPAGNIE POUR LA FABRICATION DES COMPTEURS ET MATERIEL D'USINES A GAZ) <br><br> --- | | G 01 R 29/16 |
| A | FR-A-2 182 745 (LINDERS JOHN ROBERT) <br><br> --- | | |
| A | GB-A-2 068 646 (FELTEN & GUILLEAUME) <br><br> ----- | | |

DOMAINES TECHNIQUES RECHERCHES (Int. Cl.4)

G 01 R
H 01 F
H 02 H

Le présent rapport de recherche a été établi pour toutes les revendications

| Lieu de la recherche | Date d'achèvement de la recherche | Examinateur |
|---|---|---|
| LA HAYE | 21-12-1984 | KAUFFMANN J. |